# FASCICULE DE BREVET EUROPEEN

(11) **EP 3 731 612 B1**
(45) Date de publication et mention de la délivrance du brevet: **29.09.2021**
(21) Numéro de dépôt: 20163453.2
(22) Date de dépôt: 16.03.2020
(51) Int. Cl.: H05K 7/20

(54) **DISPOSITIF DE COMMANDE A REFROIDISSEMENT OPTIMISE POUR ACTIONNEUR ELECTRIQUE**
BEDIENVORRICHTUNG MIT VERBESSERTER KÜHLUNG FÜR ELEKTRISCHES STELLGLIED
CONTROL DEVICE WITH OPTIMISED COOLING FOR ELECTRICAL ACTUATOR

(30) Priorité: 16.04.2019 FR 1904019
(43) Date de publication de la demande: 28.10.2020
(73) Titulaire: G. Cartier Technologies, 74302 Cluses (FR)
(72) Inventeur: NOURDINE, Amir, F-74300 CLUSES (FR); PIGNAL-JACQUARD, Marcel, F-74890 BONS EN CHABLAIS (FR); BREHERET, Jean-Luc, F-74300 CHATILLON SUR CLUSES (FR)
(74) Mandataire: Cabinet Poncet

(56) Documents cités:
- EP-A1- 2 988 004
- WO-A1-2018/215409
- DE-A1-102013 212 263
- US-A1- 2007 053 163

## Description

### DOMAINE TECHNIQUE DE L'INVENTION

La présente invention concerne les dispositifs de commande permettant de commander la vitesse de déplacement d'un actionneur électrique, et notamment la vitesse de rotation d'un moteur électrique à courant continu servant à la ventilation des échangeurs et du moteur d'un véhicule automobile, pour leur refroidissement.

Dans un véhicule automobile, l'échangeur thermique associé au refroidissement de l'eau servant au transfert des calories générées par le moteur thermique est généralement couplé, par mise en série dans un même flux d'air de refroidissement, avec l'échangeur servant à l'évacuation des calories issues de la compression du gaz utilisé pour la climatisation. Un ventilateur, entraîné en rotation par un moteur à courant continu, est placé devant ou derrière ces échangeurs afin de générer le flux d'air de refroidissement devant les traverser pour faciliter les échanges thermiques. Ce flux d'air de refroidissement est ensuite dirigé vers le moteur du véhicule.

Les besoins en débit d'air associés à ce couple « échangeur de refroidissement moteur - échangeur de climatisation » peuvent aller :
- d'une ventilation douce, dans le cas d'une température basse du moteur du véhicule et d'une demande modérée de la climatisation alors que le véhicule est roulant et que sa vitesse de déplacement génère déjà ainsi un flux d'air,
- à une ventilation maximale, dans le cas d'un véhicule à l'arrêt avec moteur du véhicule en surchauffe après une longue montée avec véhicule chargé, couplé à une forte température externe générant un besoin en climatisation important.

Cette différence de besoins est traitée dans la plupart des cas par des vitesses variables du ventilateur réalisées par un dispositif de commande générant une tension variable sur les bornes d'alimentation du moteur à courant continu.

Un premier type connu de dispositif de commande à tension variable utilise une résistance en série dans le circuit d'alimentation de l'actionneur électrique de type moteur à courant continu, produisant la réduction du courant et de la tension aux bornes du moteur électrique, pour une rotation à vitesse réduite. Pour produire une rotation à vitesse maximale du moteur électrique, cette résistance est court-circuitée. Ce type de dispositif de commande à résistance série est décrit par exemple dans le document FR 2 826 199 A1.

Les constructeurs automobiles recherchent actuellement l'augmentation de la durée de vie des véhicules, la réduction des pertes électriques (réduction de la consommation en carburant, ou augmentation de l'autonomie pour les véhicules électriques), la modération du coût de production et la diminution du bruit.

La technologie à résistance série, particulièrement peu onéreuse à fabriquer, peine à rester compatible avec l'augmentation de la durée de vie des véhicules car, presque exclusivement basée sur des relais électromécaniques, son nombre de commutations avant défaut est limité. Son plus gros désavantage réside dans les pertes d'énergie électrique générées par la résistance série. En effet, celles-ci atteignent couramment 100 % de l'énergie nécessaire à la ventilation au point de fonctionnement le plus utilisé.

Un second type connu de dispositif de commande à tension variable utilise un dispositif électronique de découpage de tension à modulation de largeur, généralement désigné par le sigle PWM (pulse width modulation - modulateur de largeur d'impulsion), produisant une tension de sortie qui est tantôt égale à la tension d'entrée pendant des étapes de conduction, tantôt égale à zéro pendant des étapes de non-conduction, et dont on fait varier la valeur moyenne par la modification du rapport des durées des étapes de conduction et des étapes de non-conduction. On peut ainsi moduler la vitesse de rotation du moteur électrique de façon plus fine et progressive que dans la technologie à résistance série. Ce type de dispositif électronique de commande à modulation de largeur est décrit par exemple dans le document EP 2 988 004 A1.

Cette technologie à découpage de tension à modulation de largeur PWM semble être une solution plus avantageuse, malgré un coût de fabrication largement supérieur à celui de la technologie à résistance série. Dans ce cas, pour réaliser les étapes de conduction et les étapes de non-conduction, la commutation du courant électrique d'alimentation du moteur à courant continu est assurée par une commande de commutation générant un signal de commande sensiblement carré modulé en largeur, qui pilote un circuit électronique de puissance comportant un composant électronique de type transistor à effet de champ à grille isolée (MOSFET), et une diode de roue libre connectée en polarisation inverse en parallèle sur la charge électrique à commander.

Selon le document EP 2 988 004 A1, le transistor à effet de champ et la diode de roue libre ont leur corps directement fixé à une plaque métallique formant un premier tronçon d'un conducteur de sortie, lequel participe à l'évacuation des calories générées dans ces composants.

Les documents US 2007/053163 A1, WO 2018/215409 A1 et DE 10 2013 212 263 A1 enseignent également de prévoir une conduction thermique vers un conducteur d'entrée ou de sortie.

Pendant leur fonctionnement, les composants du circuit électronique de puissance subissent un échauffement non négligeable, la température de leur jonction pouvant avoisiner les 150°C ou 175°C, sans toutefois que cela ne perturbe leur fonctionnement. La durée de vie de ces composants électroniques est très largement supérieure à celle d'un système à relais. Toutefois, du fait du dimensionnement des moteurs revu à la baisse pour des questions d'écologie, les moteurs des véhicules automobiles d'aujourd'hui ont tendance à fonctionner dans des atmosphères de plus en plus chaudes et dans des espaces de plus en plus confinés (notamment dans le cas des véhicules hybrides). Cette élévation de température diminue la durée de vie des composants électroniques, notamment ceux de type transistor à effet de champ à grille isolée (MOSFET). Et au-delà de certaines températures, il peut se produire une défaillance des composants électroniques de type transistor à effet de champ à grille isolée (MOSFET), pouvant mener à des risques d'incendie du véhicule.

Pour réduire encore l'échauffement des composants électroniques d'un dispositif de commande, on a jusqu'à présent favorisé l'évacuation des calories en couplant thermiquement les composants électroniques avec un ou plusieurs radiateurs de dissipation d'énergie calorifique qui sont eux-mêmes en contact de l'air ambiant. Les radiateurs de dissipation d'énergie calorifique sont des pièces métalliques structurées pour présenter une surface d'échange la plus large possible avec l'air ambiant. L'évacuation des calories se fait ainsi par conduction et rayonnement vers l'atmosphère ambiante. Un inconvénient est que les radiateurs de dissipation d'énergie calorifique constituent nécessairement des pièces volumineuses, qui augmentent l'encombrement du dispositif de commande, ce qui va à l'encontre de la nécessité de réduire le volume global des dispositifs de commande dans les véhicules modernes.

### EXPOSE DE L'INVENTION

Un problème proposé par la présente invention est de limiter les risques d'endommagement des composants électroniques de type transistor à effet de champ à grille isolée (MOSFET) dans un dispositif de commande électronique sans augmenter le volume global du dispositif de commande électronique. Un tel dispositif est notamment destiné à commander un actionneur électrique, par exemple en pilotant la vitesse de rotation d'un moteur électrique. Une application avantageuse est notamment la commande d'un moteur électrique à courant continu servant à la ventilation des échangeurs et du moteur d'un véhicule automobile, pour leur refroidissement.

Simultanément, l'invention vise à limiter efficacement les risques d'incendie pouvant résulter d'une défaillance des composants électroniques de type transistor à effet de champ à grille isolée (MOSFET) dans un tel dispositif électronique de commande pour actionneur électrique.

Simultanément, l'invention vise à résoudre les problèmes ci-dessus sans avoir à placer le dispositif de commande électronique directement dans le flux d'air principal de refroidissement généré par le ventilateur, le dispositif de commande électronique pouvant ainsi être placé en périphérie pour éviter d'induire une perte de charge du flux d'air principal de refroidissement.

L'idée qui est à la base de la présente invention est d'utiliser de la manière la plus efficace possible la capacité d'évacuation des calories des conducteurs électriques d'entrée et de sortie du dispositif de commande. En effet, ces conducteurs électriques servent à conduire le courant électrique principal servant à alimenter la charge, et présentent nécessairement pour cela une section transversale relativement élevée pour réduire leur résistance électrique et les pertes énergétiques qui en résulteraient lors du passage du courant électrique. La section relativement importante de ces conducteurs électriques leur confère une bonne capacité de conduction thermique, que la présente invention met à profit en prévoyant des moyens assurant un bon couplage thermique entre les composants électroniques de puissance du dispositif de commande et les conducteurs électriques d'entrée et/ou de sortie.

Pour atteindre ces objets ainsi que d'autres, la présente invention propose ainsi un dispositif de commande pour charge électrique, selon la revendication 1.

En particulier :
- le composant électronique de commutation principal est un composant CMS ayant un corps monté sur un premier substrat électriquement isolant,
- le premier substrat électriquement isolant est structuré de façon à présenter une conductivité thermique supérieure à 0,8 W/m°K, et de préférence supérieure ou égale à 5 W/m°K,
- le corps du composant électronique de commutation principal est couplé thermiquement à l'un des conducteurs électriques d'entrée ou de sortie par conduction au travers des premiers ou seconds moyens de connexion d'entrée ou de sortie respectifs,
- le premier substrat électriquement isolant est couplé thermiquement par conduction à un autre des conducteurs électriques d'entrée ou de sortie, de sorte que des calories générées dans le composant électronique de commutation principal lors de son fonctionnement sont évacuées dans au moins deux conducteurs électriques d'entrée ou de sortie distincts l'un de l'autre.

Les calories générées dans le composant électronique de commutation principal sont ainsi prélevées à la surface extérieure du corps du composant électronique de commutation principal, sont conduites d'une part vers un premier conducteur électrique d'entrée ou de sortie par l'intermédiaire des moyens de connexion d'entrée ou de sortie respectifs qui assurent simultanément la connexion électrique entre le composant électronique de commutation principal et ledit premier conducteur électrique d'entrée ou de sortie, et sont conduites d'autre part vers un second conducteur électrique d'entrée ou de sortie, différent dudit premier conducteur électrique d'entrée ou de sortie, par l'intermédiaire du premier substrat électriquement isolant qui lui-même présente une conductivité thermique appropriée et qui est couplé thermiquement d'une part au corps du composant électronique de commutation principal et audit second conducteur électrique d'entrée ou de sortie.

Grâce à ce double couplage thermique avec deux conducteurs électriques différents, l'évacuation des calories générées dans le composant électronique de commutation principal est optimisée, et il devient possible de réduire suffisamment la température de ce composant sans avoir recours nécessairement à un couplage thermique avec un radiateur de dissipation d'énergie calorifique.

Selon un mode de réalisation pratique, on peut prévoir que :
- le corps du composant électronique de commutation principal est couplé thermiquement au premier conducteur électrique de sortie par conduction au travers des premiers moyens de connexion de sortie,
- le premier substrat électriquement isolant est couplé thermiquement par conduction à l'un des conducteurs électriques d'entrée.

Pour optimiser la conduction thermique assurée par les premiers moyens de connexion de sortie, on peut avantageusement prévoir que :
- les premiers moyens de connexion de sortie comprennent une première lame conductrice de l'électricité, ayant une première extrémité de première lame et une deuxième extrémité de première lame,
- la première extrémité de première lame est connectée électriquement au composant électronique de commutation principal par l'intermédiaire d'une première piste conductrice portée par le premier substrat électriquement isolant,
- la première extrémité de première lame est en contact thermique selon une première surface de contact avec le premier substrat électriquement isolant par l'intermédiaire de ladite première piste conductrice,
- la deuxième extrémité de première lame est solidaire du premier conducteur électrique de sortie, de façon à assurer simultanément la conduction thermique et la conduction électrique entre ladite première lame et ledit premier conducteur de sortie.

Un intérêt d'utiliser une première lame est à la fois de constituer un conducteur électrique ayant une section transversale importante pour la conduction du courant électrique et la conduction des calories, et de faciliter son assemblage par brasure à la première piste conductrice tout en optimisant sa surface de contact avec le premier substrat électriquement isolant pour une bonne conduction thermique.

Un autre intérêt d'utiliser une première lame est de pouvoir donner à cette première lame un profil longitudinal incurvé, susceptible d'autoriser un déplacement relatif entre le premier conducteur de sortie et le premier substrat électriquement isolant sans induire, sur le premier substrat électriquement isolant, des efforts mécaniques risquant de provoquer sa détérioration en cas d'utilisation d'un matériau fragile Du fait des variations de températures auxquelles est soumis le dispositif de commande, il peut en effet se produire des phénomènes de dilatation et de retrait induisant des variations dimensionnelles de la distance entre le substrat électriquement isolant du circuit électronique de puissance et le conducteur de sortie. Le profil longitudinal non rectiligne de la lame lui procure une capacité de déformation longitudinale à faible résistance mécanique, permettant d'absorber ces variations dimensionnelles sans induire de contraintes mécaniques excessives sur le substrat supportant les composants du dispositif de commande.

Dans un mode de réalisation avantageux, le dispositif de commande est tel que :
- le composant électronique de commutation principal est un premier transistor à effet de champ à grille isolée,
- la diode de roue libre est constituée par la diode de structure d'un deuxième transistor à effet de champ à grille isolée de type CMS ayant un corps monté sur un deuxième substrat électriquement isolant,
- la commande de commutation est configurée pour mettre à l'état conducteur le deuxième transistor à effet de champ à grille isolée pendant que le premier transistor à effet de champ à grille isolée est à l'état non conducteur,
- le deuxième transistor à effet de champ à grille isolée est connecté électriquement au deuxième conducteur électrique d'entrée par des deuxièmes moyens de connexion d'entrée, et est connecté électriquement au premier conducteur électrique de sortie par des deuxièmes moyens de connexion de sortie, pour être en parallèle avec la charge électrique à commander,
- le corps du deuxième transistor à effet de champ à grille isolée est couplé thermiquement au premier conducteur électrique de sortie par conduction au travers des deuxièmes moyens de connexion de sortie,
- le deuxième substrat électriquement isolant présente une conductivité thermique supérieure à 0,8 W/m°K, et de préférence supérieure ou égale à 5 W/m°K,
- le deuxième substrat électriquement isolant est couplé thermiquement par conduction au deuxième conducteur électrique de sortie,
de sorte que les calories générées dans le deuxième transistor à effet de champ à grille isolée lors de son fonctionnement sont évacuées dans au moins deux conducteurs électriques distincts l'un de l'autre.

Un intérêt de ce mode de réalisation est que les calories générées par le deuxième transistor à effet de champ à grille isolée sont beaucoup plus faibles que les calories générées par une diode de roue libre, ce qui permet de réduire encore l'échauffement des composants de puissance du dispositif de commande. Un autre intérêt est que, grâce à ce double couplage thermique avec deux conducteurs électriques différents, l'évacuation des calories générées dans le deuxième transistor à effet de champ à grille isolée est optimisée, et il devient possible de réduire suffisamment la température de ce composant sans avoir recours nécessairement à un couplage thermique avec un radiateur de dissipation d'énergie calorifique.

Pour réaliser à la fois une bonne isolation électrique et une bonne conductivité thermique, le premier substrat et/ou le deuxième substrat peuvent avantageusement être en céramique, ou comprendre une couche en aluminium associée à une couche électriquement isolante.

Pour optimiser la conduction thermique assurée par les deuxièmes moyens de connexion de sortie, on peut avantageusement prévoir que :
- les deuxièmes moyens de connexion de sortie comprennent une deuxième lame conductrice ayant une première extrémité de deuxième lame et une deuxième extrémité de deuxième lame,
- la première extrémité de deuxième lame est connectée électriquement au composant électronique de commutation principal par l'intermédiaire d'une deuxième piste conductrice portée par le deuxième substrat électriquement isolant,
- la première extrémité de deuxième lame est en contact thermique avec le deuxième substrat électriquement isolant selon une troisième surface de contact par l'intermédiaire de ladite deuxième piste conductrice,
- la deuxième extrémité de deuxième lame est solidaire du premier conducteur électrique de sortie, de façon à assurer simultanément la conduction thermique et la conduction électrique entre ladite deuxième lame et ledit premier conducteur de sortie.

Les avantages de cette structuration des deuxièmes moyens de connexion de sortie sont les mêmes que ceux exposés précédemment en relation avec les premiers moyens de connexion de sortie.

Selon une première réalisation pratique, un dispositif de commande selon la présente invention peut être tel que :
- le deuxième conducteur électrique d'entrée et le deuxième conducteur électrique de sortie sont en continuité l'un de l'autre par l'intermédiaire d'une plaque métallique commune, et sont destinés à être connectés à une masse commune et à la borne négative de la source d'alimentation électrique à courant continu,
- le premier conducteur électrique d'entrée est destiné à être connecté à la borne positive de la source d'alimentation électrique à courant continu,
- le premier substrat électriquement isolant et le deuxième substrat électriquement isolant forment un seul et unique substrat au contact de la plaque métallique commune,
de sorte que les calories générées dans le premier transistor à effet de champ à grille isolée et dans le deuxième transistor à effet de champ à grille isolée lors de leur fonctionnement sont évacuées à la fois dans le premier conducteur électrique de sortie, dans le deuxième conducteur électrique de sortie et dans le deuxième conducteur électrique d'entrée.

Selon une seconde réalisation pratique, un dispositif de commande selon la présente invention peut être tel que :
- le deuxième conducteur électrique d'entrée et le deuxième conducteur électrique de sortie sont connectés électriquement l'un à l'autre,
- le premier conducteur électrique d'entrée est destiné à être connecté à une masse commune et à la borne négative de la source d'alimentation électrique à courant continu,
- le deuxième conducteur électrique d'entrée est destiné à être connecté à la borne positive de la source d'alimentation électrique à courant continu,
- le premier substrat électriquement isolant est au contact d'une première plaque métallique qui est en continuité avec le premier conducteur électrique d'entrée,
- le second substrat électriquement isolant est au contact d'une deuxième plaque métallique qui est en continuité avec le deuxième conducteur électrique de sortie, de sorte que les calories générées dans le premier transistor à effet de champ à grille isolée lors de son fonctionnement sont évacuées à la fois dans le premier conducteur électrique de sortie et dans le premier conducteur électrique d'entrée, et de sorte que les calories générées dans le deuxième transistor à effet de champ à grille isolée lors de son fonctionnement sont évacuées à la fois dans le premier conducteur électrique de sortie et dans le deuxième conducteur électrique de sortie.

Bien qu'il soit généralement possible, selon la présente invention, d'éviter le recours à un radiateur de dissipation d'énergie calorifique, puisque la dissipation des calories par les conducteurs électriques est optimisée, il reste néanmoins possible d'utiliser en outre au moins un radiateur de dissipation d'énergie calorifique, couplé thermiquement au moins au premier substrat électriquement isolant.

Dans le cas où le dispositif de commande comporte en outre un relais électromécanique ayant un contact connecté électriquement entre l'un des moyens de connexion d'entrée et le conducteur électrique d'entrée destiné à être connecté à la borne positive de la source d'énergie électrique à courant continu, il est avantageux d'optimiser l'évacuation des calories générées dans la bobine de commande de commutation dudit contact. Pour cela, la bobine de commande de commutation dudit contact peut avantageusement être couplée thermiquement audit conducteur électrique d'entrée destiné à être connecté à la borne positive de la source d'alimentation électrique à courant continu. On utilise ainsi quatre conducteurs électriques pour évacuer les calories générées dans le dispositif de commande selon la présente invention.

l'invention peut avantageusement être appliquée à un véhicule automobile à échangeur thermique et ventilateur actionné par un moteur électrique pour ventiler l'échangeur thermique. Dans ce cas, le moteur électrique est commandé par un dispositif de commande tel que défini ci-dessus.

Dans ce cas, le ventilateur peut avantageusement être monté sur un support transversal de fixation sensiblement plan à première face opposée à une deuxième face, le ventilateur étant apte à générer un flux d'air traversant le support depuis la première face vers la deuxième face ; le support transversal de fixation comporte, en périphérie du ventilateur, une lumière de fixation pour la réception du dispositif de commande, et le dispositif de commande est fixé dans ladite lumière. Les ou les conducteurs électriques de sortie du dispositif de commande peuvent avantageusement traverser un flux d'air généré par le ventilateur.

### DESCRIPTION SOMMAIRE DES DESSINS

D'autres objets, caractéristiques et avantages de la présente invention ressortiront de la description suivante de modes de réalisation particuliers, faite en relation avec les figures jointes, parmi lesquelles :

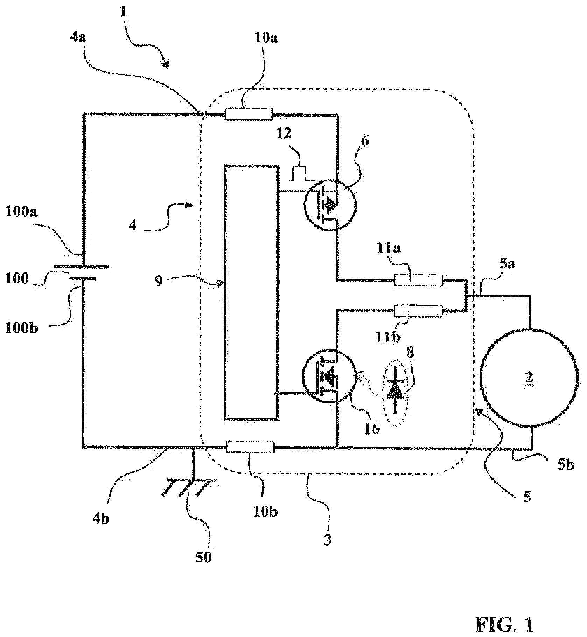

[Fig.1] La figure 1 est une représentation schématique du circuit électrique d'un premier mode de réalisation de dispositif de commande pour charge électrique selon l'invention ;

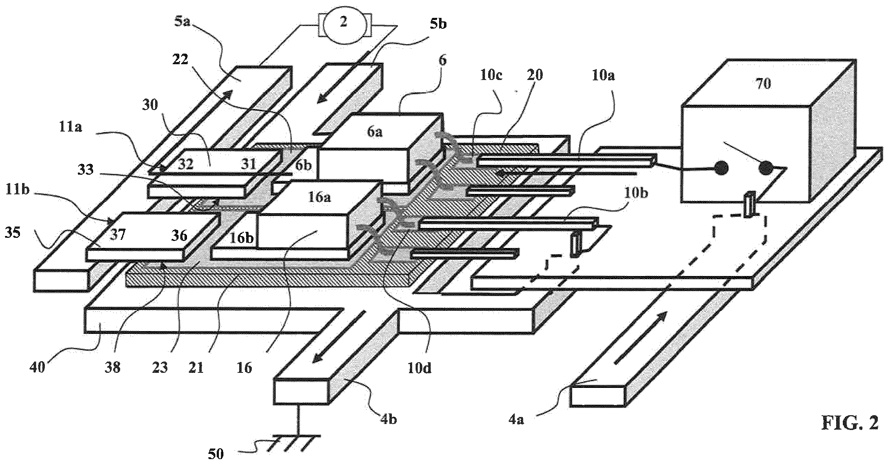

[Fig.2] La figure 2 est une vue schématique en perspective d'une implantation des composants de puissance du circuit électrique selon le mode de réalisation de la figure 1, illustrant en outre le passage du courant électrique lors de l'activation du premier transistor à effet de champ à grille isolée ;

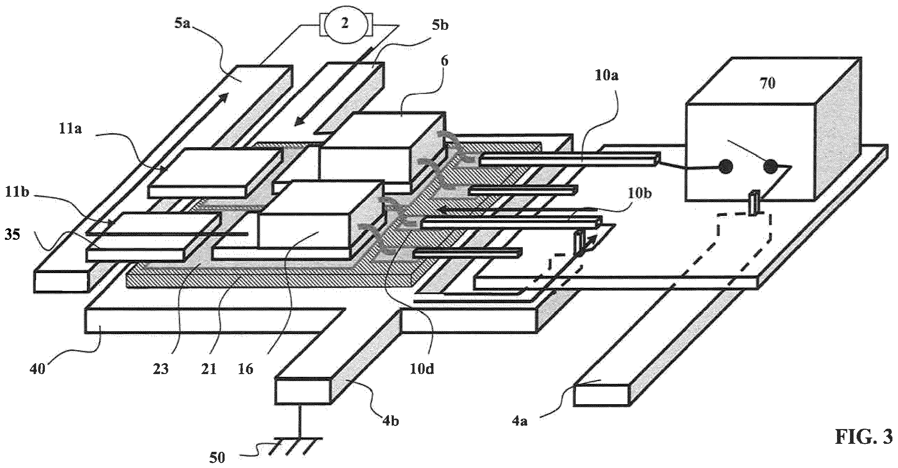

[Fig.3] La figure 3 est une vue schématique en perspective de cette même implantation des composants de puissance du circuit électrique selon le mode de réalisation de la figure 1, illustrant le passage du courant électrique lors de l'activation du deuxième transistor à effet de champ à grille isolée pour le fonctionnement en roue libre ;

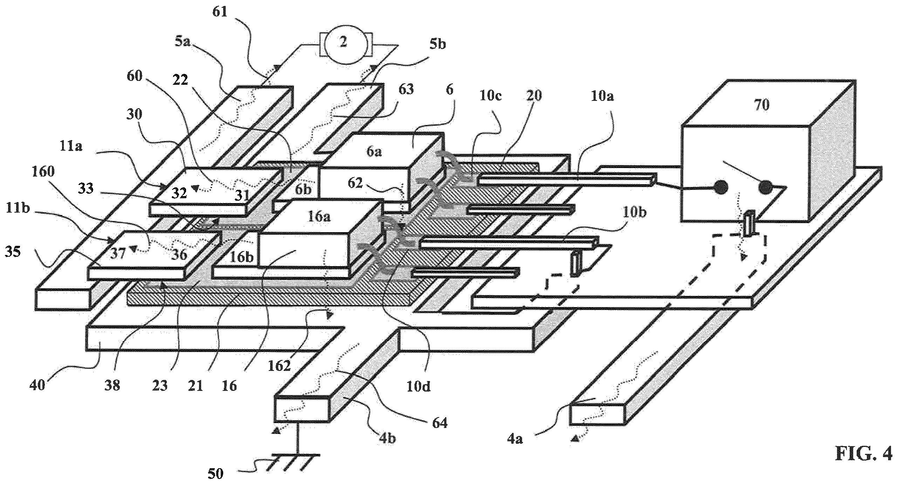

[Fig.4] La figure 4 est une vue schématique en perspective de cette même implantation des composants de puissance du circuit électrique selon le mode de réalisation de la figure 1, illustrant les passages de conduction thermique entre les composants de puissance et les conducteurs électriques d'entrée et de sortie ;

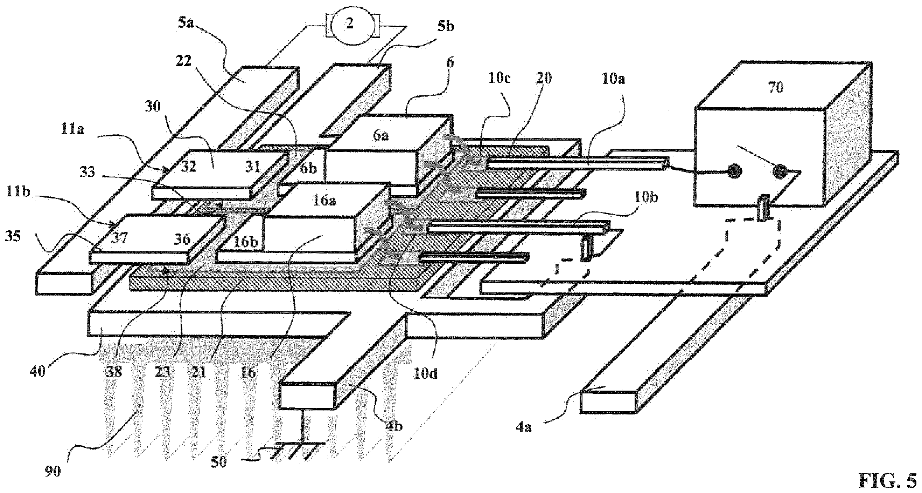

[Fig.5] La figure 5 est une autre vue schématique en perspective de cette même implantation des composants de puissance du circuit électrique selon le mode de réalisation de la figure 1, illustrant une variante dans laquelle est ajouté un radiateur de dissipation d'énergie calorifique ;

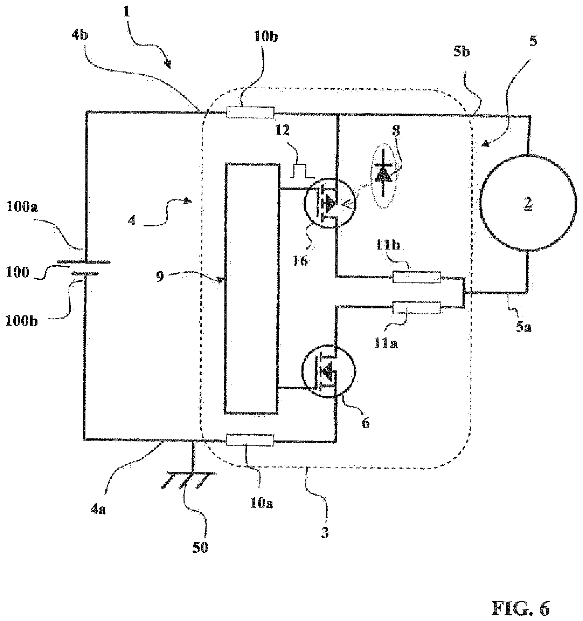

[Fig.6] La figure 6 est une représentation schématique du circuit électrique d'un deuxième mode de réalisation de dispositif de commande pour charge électrique selon l'invention ;

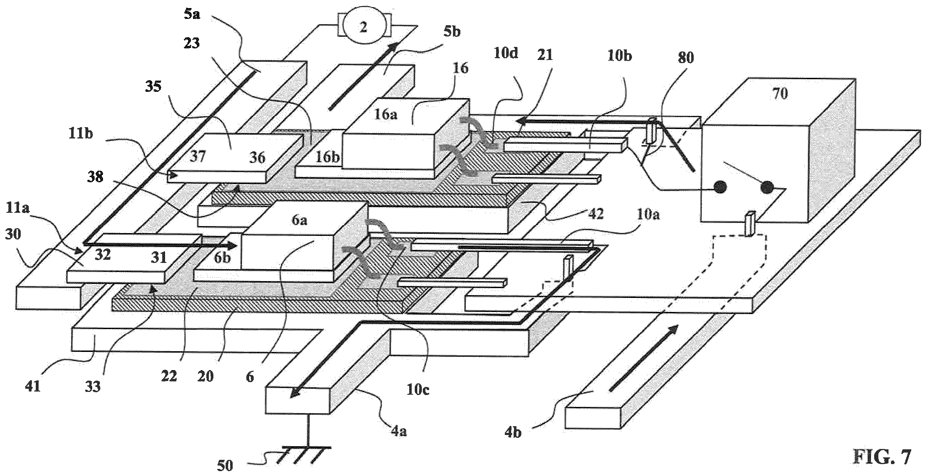

[Fig.7] La figure 7 est une vue schématique en perspective d'une implantation des composants de puissance du circuit électrique selon le mode de réalisation de la figure 6, illustrant en outre le passage du courant électrique lors de l'activation du premier transistor à effet de champ à grille isolée ;

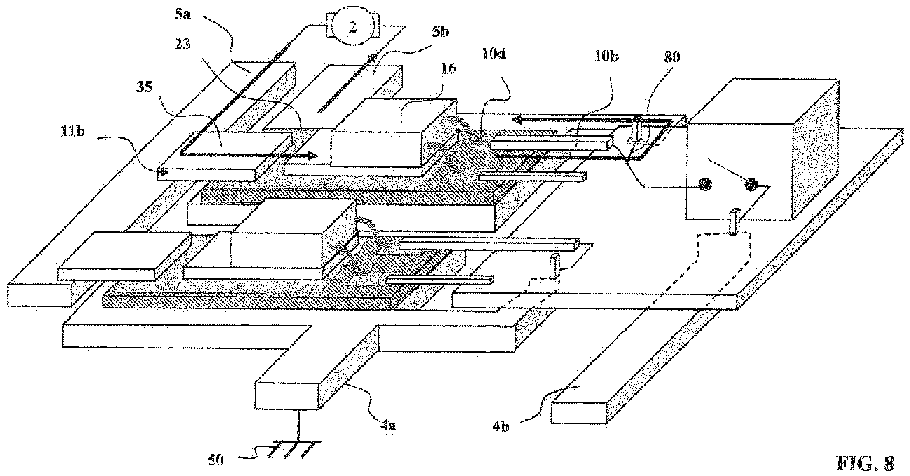

[Fig.8] La figure 8 est une vue schématique en perspective de cette même implantation des composants de puissance du circuit électrique selon le mode de réalisation de la figure 6, illustrant le passage du courant électrique lors de l'activation du deuxième transistor à effet de champ à grille isolée pour le fonctionnement en roue libre ;

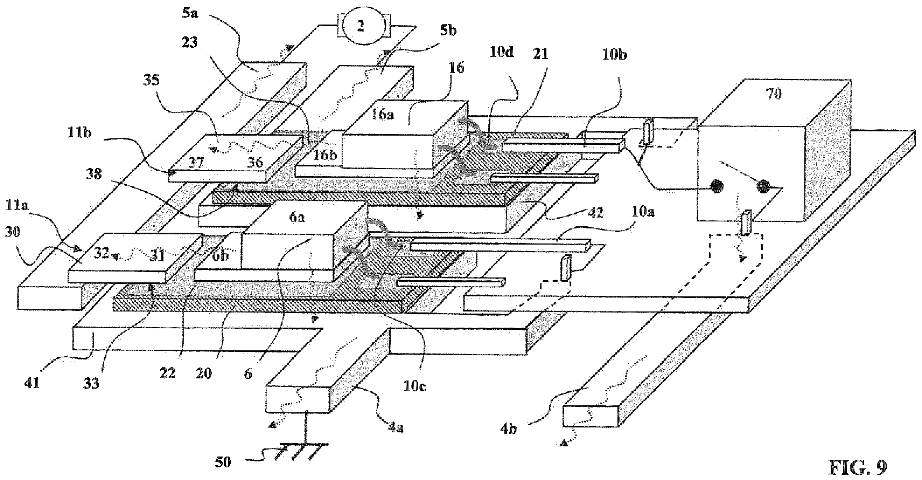

[Fig.9] La figure 9 est une vue schématique en perspective de cette même implantation des composants de puissance du circuit électrique selon le mode de réalisation de la figure 6, illustrant les passages de conduction thermique entre les composants de puissance et les conducteurs électriques d'entrée et de sortie ; et

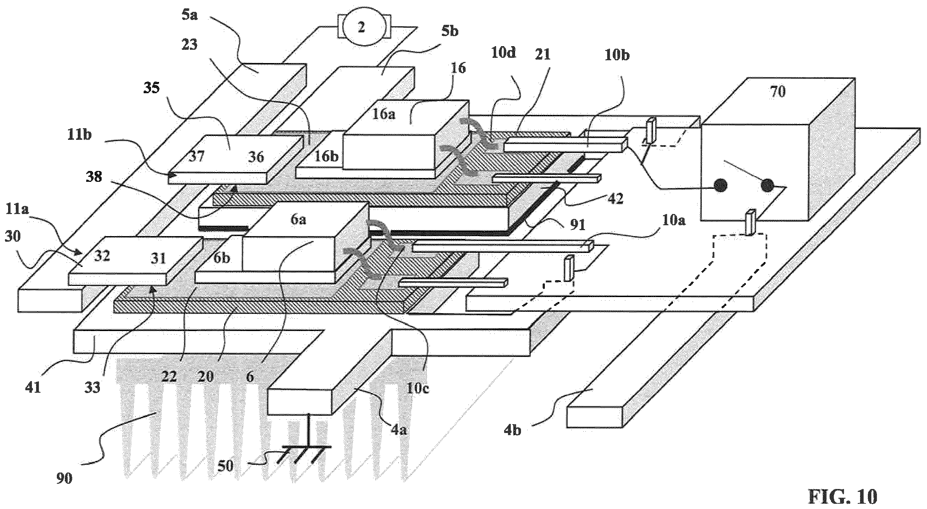

[Fig.10] La figure 10 est une autre vue schématique en perspective de cette même implantation des composants de puissance du circuit électrique selon le mode de réalisation de la figure 6, illustrant une variante dans laquelle est ajouté un radiateur de dissipation d'énergie calorifique.

### DESCRIPTION DES MODES DE REALISATION PREFERES

Sur la figure 1 est illustré schématiquement le circuit électrique d'un premier mode de réalisation particulier de dispositif de commande 1 pour charge électrique 2 selon l'invention. La charge électrique 2 est ici un moteur électrique à courant continu, mais cela n'est nullement limitatif de la présente invention.

Le dispositif de commande 1 comprend un circuit électronique de puissance 3, ayant une connectique d'entrée 4 destinée à être connectée à une source d'alimentation électrique à courant continu 100, et ayant une connectique de sortie 5 destinée à être connectée au moteur électrique 2.

En l'espèce, la connectique d'entrée 4 comprend un premier conducteur électrique d'entrée 4a et un second conducteur électrique d'entrée 4b, tandis que la connectique de sortie 5 comprend un premier conducteur électrique de sortie 5a et un second conducteur électrique de sortie 5b.

Chacun des conducteurs électriques d'entrée et de sortie forme une broche de connecteur permettant la connexion par enfichage avec un câble métallique conducteur qui prolonge le conducteur électrique d'entrée ou de sortie jusqu'à la source d'alimentation électrique à courant continu 100 ou jusqu'au moteur électrique 2.

Dans ce premier mode de réalisation, le deuxième conducteur électrique d'entrée 4b et le deuxième conducteur électrique de sortie 5b sont connectés l'un à l'autre et à une masse commune 50, qui est elle-même connectée à la borne négative 100b de la source d'alimentation électrique à courant continu 100. Le moteur électrique 2 est ainsi connecté entre le premier conducteur électrique de sortie 5a et la masse commune 50, de sorte que sa carcasse est à la masse.

Le moteur électrique 2 à courant continu sert par exemple à la ventilation des échangeurs et du moteur d'un véhicule automobile, pour leur refroidissement. La source d'alimentation électrique à courant continu 100 est ainsi constituée par la batterie du véhicule.

Le circuit électronique de puissance 3 comprend un composant électronique de commutation principal, sous forme d'un premier transistor 6 à effet de champ à grille isolée à canal P, de type CMS (composant monté en surface), dont la source est connectée au premier conducteur électrique d'entrée 4a par des premiers moyens de connexion d'entrée 10a, et dont le drain est connecté au premier conducteur électrique de sortie 5a par des premiers moyens de connexion de sortie 11a pour être en série avec le moteur électrique 2. Le circuit électronique de puissance 3 comprend une diode de roue libre 8 connectée en polarisation inverse sur la connectique de sortie 5. La diode de roue libre 8 permet la circulation du courant généré par la composante inductive du moteur électrique 2 lorsque le premier transistor 6 à effet de champ à grille isolée est bloqué (c'est-à-dire est à l'état non-conducteur).

La commande du premier transistor 6 à effet de champ à grille isolée permet un découpage de tension à modulation de largeur, généralement désigné par le sigle PWM (pulse width modulation - modulateur de largeur d'impulsion), produisant une tension de sortie aux bornes du moteur électrique 2 qui est tantôt égale à la tension d'entrée pendant les étapes de conduction du premier transistor 6 à effet de champ à grille isolée, tantôt sensiblement égale à zéro pendant les étapes de non-conduction du premier transistor 6 à effet de champ à grille isolée, et dont on fait varier la valeur moyenne par la modification du rapport des durées des étapes de conduction et des étapes de non-conduction du premier transistor 6 à effet de champ à grille isolée. On pilote ainsi la vitesse du moteur électrique 2 pour l'adapter progressivement aux besoins en refroidissement du véhicule.

Dans le mode de réalisation illustré sur la figure 1, la diode de roue libre 8 est en fait constituée par la diode de structure d'un deuxième transistor 16 à effet de champ à grille isolée.

Le deuxième transistor 16 à effet de champ à grille isolée est à canal N, de type CMS (composant monté en surface). Sa source est connectée au deuxième conducteur électrique d'entrée 4b par des deuxièmes moyens de connexion d'entrée 10b, et son drain est connecté au premier conducteur électrique de sortie 5a par des deuxièmes moyens de connexion de sortie 11b.

Le dispositif de commande 1 comprend une commande de commutation 9 à microcontrôleur, apte à générer sur la grille dudit premier transistor 6 à effet de champ à grille isolée un signal de commande 12 sensiblement carré modulé en largeur.

La commande de commutation 9 à microcontrôleur constitue également des moyens de pilotage configurés pour mettre à l'état conducteur le deuxième transistor 16 à effet de champ à grille isolée pendant une partie des étapes de non-conduction du premier transistor 6 à effet de champ à grille isolée.

On considère maintenant, sur la figure 2, la disposition schématique des composants du dispositif de commande 1 selon le premier mode de réalisation. Le premier transistor 6 à effet de champ à grille isolée et le deuxième transistor 16 à effet de champ à grille isolée sont tous deux des composants de type CMS (composant monté en surface), comportant un boîtier, respectivement 6a ou 16a, solidaire d'une semelle métallique, respectivement 6b ou 16b. La semelle métallique 6b ou 16b est brasée sur une piste conductrice de sortie, respectivement 22 ou 23, elle-même portée par un substrat électriquement isolant, respectivement 20 ou 21. La source du premier transistor 6 à effet de champ à grille isolée est brasée sur une piste conductrice d'entrée 10c portée par le premier substrat électriquement isolant 20, tandis que la source du deuxième transistor 16 à effet de champ à grille isolée est brasée sur une piste conductrice d'entrée 10d portée par le deuxième substrat électriquement isolant 21.

Les premiers moyens de connexion de sortie 11a sont plus particulièrement détaillés sur la figure 2 en ce qui concerne le premier transistor 6 à effet de champ à grille isolée, et comprennent dans ce cas une première lame 30 conductrice de l'électricité, ayant une première extrémité 31 de première lame et une deuxième extrémité 32 de première lame.

La première extrémité 31 de première lame est connectée électriquement au premier transistor 6 à effet de champ à grille isolée par l'intermédiaire d'une première piste conductrice de sortie 22 portée par le premier substrat électriquement isolant 20 sur lequel est monté le boîtier du premier transistor 6 à effet de champ à grille isolée. En pratique, la première extrémité 31 de première lame est brasée, selon une première surface de contact 33, sur la première piste conductrice de sortie 22, de sorte qu'elle se trouve en contact thermique selon ladite première surface de contact 33 avec le premier substrat électriquement isolant 20 par l'intermédiaire de ladite première piste conductrice de sortie 22. La deuxième extrémité 32 de première lame est solidaire du premier conducteur électrique de sortie 5a, de façon à assurer simultanément la conduction thermique et la conduction électrique entre ladite première lame 30 et ledit premier conducteur électrique de sortie 5a. Selon une première possibilité, la deuxième extrémité 32 de première lame est soudée électriquement ou par laser au premier conducteur électrique de sortie 5a. Selon une seconde possibilité, la première lame 30 peut-être d'une seule pièce avec le premier conducteur électrique de sortie 5a, dont elle constitue une protubérance de connexion.

De même, les deuxièmes moyens de connexion de sortie 11b comprennent dans ce cas une deuxième lame 35 conductrice de l'électricité, ayant une première extrémité 36 de deuxième lame et une deuxième extrémité 37 de deuxième lame.

La première extrémité 36 de deuxième lame est connectée électriquement au deuxième transistor 16 à effet de champ à grille isolée par l'intermédiaire d'une deuxième piste conductrice de sortie 23 portée par le deuxième substrat électriquement isolant 21 sur lequel est monté le boîtier du deuxième transistor 16 à effet de champ à grille isolée. En pratique, la première extrémité 36 de deuxième lame est brasée, selon une deuxième surface de contact 38, sur la deuxième piste conductrice de sortie 23, de sorte qu'elle se trouve en contact thermique selon ladite deuxième surface de contact 38 avec le deuxième substrat électriquement isolant 21 par l'intermédiaire de ladite deuxième piste conductrice de sortie 23. La deuxième extrémité 37 de deuxième lame est solidaire du premier conducteur électrique de sortie 5a, de façon à assurer simultanément la conduction thermique et la conduction électrique entre ladite deuxième lame 35 et ledit premier conducteur électrique de sortie 5a. Selon une première possibilité, la deuxième extrémité 37 de deuxième lame est soudée électriquement ou par laser au premier conducteur électrique de sortie 5a. Selon une seconde possibilité, la deuxième lame 35 peut-être d'une seule pièce avec le premier conducteur électrique de sortie 5a, dont elle constitue une protubérance de connexion.

Dans la réalisation illustrée schématiquement sur la figure 2, les première lame 30 et deuxième lame 35 sont représentées planes. Toutefois, on pourra trouver avantage à conformer la première lame 30 et la deuxième lame 35 selon un profil longitudinal incurvé.

Dans le mode de réalisation illustré sur la figure 2, le deuxième conducteur électrique d'entrée 4b et le deuxième conducteur électrique de sortie 5b sont en continuité l'un de l'autre par l'intermédiaire d'une plaque métallique commune 40, et sont destinés à être connectés tous deux à une masse commune 50 et à la borne négative 100b de la source d'alimentation électrique à courant continu 100. Dans ce cas, le premier substrat électriquement isolant 20 et le deuxième substrat électriquement isolant 21 peuvent avantageusement former un seul et unique substrat, au contact de la plaque métallique commune 40.

Les organes constitutifs du dispositif de commande 1 ont tout d'abord pour fonction de conduire le courant électrique d'alimentation de la charge électrique 2 qui est elle-même connectée entre le premier conducteur de sortie 5a et le deuxième conducteur de sortie 5b. Le premier conducteur d'entrée 4a est connecté à la borne positive 100a de la source d'alimentation électrique à courant continu 100, tandis que le deuxième conducteur d'entrée 4b est connecté à la masse commune 50 et à la borne négative 100b de la source d'alimentation électrique à courant continu 100. Pour illustrer cela, on a représenté sur la figure 2 par des flèches droites le passage du courant électrique lors de l'activation du premier transistor 6 à effet de champ à grille isolée, et on a illustré sur la figure 3 par des flèches droites le passage du courant électrique lors du fonctionnement en roue libre par activation du deuxième transistor 16 à effet de champ à grille isolée.

Mais, selon l'invention, les organes constitutifs du dispositif de commande 1 ont en outre pour fonction de conduire vers l'extérieur, c'est-à-dire vers les conducteurs d'entrée et de sortie, les calories générées dans les transistors 6 et 16 à effet de champ à grille isolée. Pour illustrer cela, on a illustré sur la figure 4, par des flèches ondulées, les passages de progression de l'énergie calorifique depuis les boîtiers des transistors 6 et 16 à effet de champ à grille isolée jusqu'aux conducteurs d'entrée et de sortie.

En l'espèce, les calories générées par le premier transistor 6 à effet de champ à grille isolée progressent par un premier chemin jusqu'au premier conducteur électrique de sortie 5a, progressent simultanément par un deuxième chemin jusqu'au deuxième conducteur électrique de sortie 5b, et progressent simultanément par un troisième chemin jusqu'au deuxième conducteur électrique d'entrée 4b.

Le premier chemin, illustré par les flèches 60 et 61, est formé par la brasure entre la semelle métallique 6b du premier transistor 6 à effet de champ à grille isolée et la première piste conductrice de sortie 22, puis par la première piste conductrice de sortie 22 en parallèle avec le premier substrat électriquement isolant 20, puis par la brasure entre la première extrémité 31 de première lame 30 et la première piste conductrice de sortie 22, et enfin par la première lame 30 elle-même dont la deuxième extrémité 32 est soudée ou solidaire du premier conducteur de sortie 5a.

Le deuxième chemin, illustré par les flèches 62 et 63, est formé par la brasure entre la semelle métallique 6b du premier transistor 6 à effet de champ à grille isolée et la première piste conductrice de sortie 22, puis par l'épaisseur de la première piste conductrice de sortie 22, puis par le contact intime entre la première piste conductrice de sortie 22 et le premier substrat électriquement isolant 20, puis par l'épaisseur du premier substrat électriquement isolant 20, puis par le contact intime (par exemple par collage ou pression) entre le premier substrat électriquement isolant 20 et la plaque métallique commune 40, puis par la plaque métallique commune 40 qui conduit directement au deuxième conducteur de sortie 5b avec lequel elle est formée d'une seule pièce.

Le troisième chemin, illustré par les flèches 62 et 64, est formé par la brasure entre la semelle métallique 6b du premier transistor 6 à effet de champ à grille isolée et la première piste conductrice de sortie 22, puis par l'épaisseur de la première piste conductrice de sortie 22, puis par le contact intime entre la première piste conductrice de sortie 22 et le premier substrat électriquement isolant 20, puis par l'épaisseur du premier substrat électriquement isolant 20, puis par le contact intime entre le premier substrat électriquement isolant 20 et la plaque métallique commune 40, puis par la plaque métallique commune 40 qui conduit directement au deuxième conducteur d'entrée 4b avec lequel elle est formée d'une seule pièce.

De même, les calories générées par le deuxième transistor 16 à effet de champ à grille isolée progressent de façon similaire par un premier chemin, illustré par les flèches 160 et 61, jusqu'au premier conducteur électrique de sortie 5a, progressent simultanément par un deuxième chemin, illustré par les flèches 162 et 63, jusqu'au deuxième conducteur électrique de sortie 5b, et progressent simultanément par un troisième chemin, illustré par les flèches 162 et 64, jusqu'au deuxième conducteur électrique d'entrée 4b.

Pour une bonne efficacité de la conduction thermique des deuxième et troisième chemins, il est nécessaire que le premier substrat électriquement isolant 20 et le deuxième substrat électriquement isolant 21, ou le substrat commun, soient structurés de façon à présenter une conductivité thermique suffisamment élevée, par exemple supérieure à 0,8 W/m°K, de préférence supérieure ou égale à 5 W/m°K, et plus avantageusement supérieure à 20 W/m°k. De telles valeurs de conductivité thermique peuvent être obtenues en utilisant une céramique à bonne conductivité thermique.

Parmi les céramiques à bonne conductivité thermique, on pourra par exemple choisir : un oxyde d'aluminium (AL₂O₃), permettant d'obtenir un substrat électriquement isolant dont la conductivité thermique est de l'ordre de 30 W/m.°K, ou un nitrure d'aluminium (AIN), permettant d'obtenir un substrat électriquement isolant dont la conductivité thermique est de l'ordre de 200 W/m.°K.

En alternative à un substrat électriquement isolant comportant une couche en céramique, on peut recourir à un substrat comprenant une couche métallique associée à une couche électriquement isolante. La couche électriquement isolante peut être formée par un diélectrique thermiquement conducteur. La couche métallique est en un métal ou alliage de métal ayant une grande conductivité thermique. On pourra par exemple choisir, pour réaliser la couche métallique du substrat électriquement isolant : de l'aluminium dont la conductivité thermique est de l'ordre de 30 W/m.°K, ou du cuivre dont la conductivité thermique est de l'ordre de 200 W/m.°K. Ladite couche métallique est recouverte d'une couche diélectrique thermiquement conductrice dont la conductivité thermique est de l'ordre de 8 W/m.°K. Par comparaison, un substrat électriquement isolant en époxy renforcé par de la fibre de verre, couramment utilisé pour les substrat électriquement isolants de circuits électroniques, présente généralement une conductivité thermique de l'ordre de 0,8 W/m.°K.

Une variante de ce premier mode de réalisation est illustrée sur la figure 5 : dans ce cas, il est aisé de fixer, en face inférieure de la plaque métallique commune 40, un radiateur de dissipation d'énergie calorifique 90 permettant d'augmenter encore l'évacuation des calories vers l'atmosphère extérieure. Il n'y a pas besoin d'isoler électriquement le radiateur de dissipation d'énergie calorifique 90, qui se trouve au même potentiel de masse que le deuxième conducteur électrique d'entrée 4b et le deuxième conducteur électrique de sortie 5b.

Un deuxième mode de réalisation particulier de dispositif de commande 1 pour actionneur électrique 2 selon l'invention est illustré sur la figure 6, lequel est très similaire au premier mode de réalisation : les éléments qui y sont identifiés par des références numériques identiques à celles utilisées dans le cadre du premier mode de réalisation désignent des éléments identiques à ceux décrits dans le cadre du premier mode de réalisation. En conséquence, leur description ne sera pas répétée.

Ce deuxième mode de réalisation diffère du premier mode de réalisation notamment en ce que l'actionneur électrique (moteur) 2 est connecté entre le premier conducteur électrique de sortie 5a et la borne positive 100a de la source d'alimentation électrique à courant continu 100.

Dans ce cas, le premier transistor 6 à effet de champ à grille isolée est à canal N, de type CMS (composant monté en surface), dont la source est connectée au premier conducteur électrique d'entrée 4a par des premiers moyens de connexion d'entrée 10a, et dont le drain est connecté au premier conducteur électrique de sortie 5a par des premiers moyens de connexion de sortie 11a pour être en série avec le moteur électrique 2. Le circuit électronique de puissance 3 comprend une diode de roue libre 8 connectée en polarisation inverse sur la connectique de sortie 5, et qui est dans ce cas constituée par la diode de structure d'un deuxième transistor 16 à effet de champ à grille isolée, à canal P, de type CMS.

Comme illustré notamment sur la figure 7, le deuxième conducteur d'entrée 4b et le deuxième conducteur de sortie 5b sont connectés électriquement l'un à l'autre par une liaison électrique 80. Dans ce mode de réalisation, les dilatations thermiques des composants métalliques obligent à prévoir que le premier substrat électriquement isolant 20 et le deuxième substrat électriquement isolant 21 soient séparés l'un de l'autre, fixés respectivement sur une première plaque métallique 41 solidaire du premier conducteur d'entrée 4a, et sur une deuxième plaque métallique 42 solidaire du deuxième conducteur de sortie 5b.

Pour le reste, la constitution du dispositif de commande 1 de ce second mode de réalisation est similaire de celle du premier mode de réalisation, et le fonctionnement est similaire : le fonctionnement électrique est illustré sur les figures 7 et 8, tandis que le fonctionnement thermique est illustré sur la figure 9.

Une variante de ce deuxième mode de réalisation est illustrée sur la figure 10 : dans ce cas, il est aisé de fixer, en face inférieure de la première plaque métallique 41, un radiateur de dissipation d'énergie calorifique 90 permettant d'augmenter encore l'évacuation des calories vers l'atmosphère extérieure. Il n'y a pas besoin d'isoler électriquement le radiateur de dissipation d'énergie calorifique 90 vis-à-vis de la première plaque métallique 41, qui se trouve au même potentiel de masse que le premier conducteur électrique d'entrée 4a. Par contre, il convient de prévoir un isolant 91 entre le radiateur de dissipation d'énergie calorifique 90 et la deuxième plaque métallique 42.

Dans les modes de réalisation qui ont été explicitement décrits, la diode de roue libre 8 est constituée par la diode de structure du deuxième transistor 16 à effet de champ à grille isolée. Le deuxième transistor à effet de champ à grille isolée présente, à l'état conducteur, une résistance résiduelle (rds on) très faible, qui induit des pertes beaucoup plus faibles que la tension de jonction d'une diode de roue libre « standard » à l'état conducteur. De la sorte, la mise en conduction du deuxième transistor à effet de champ à grille isolée permet de limiter les pertes pendant la phase de passage du courant de roue libre. Ces modes de réalisation sont donc avantageux pour réduire les pertes d'énergie électrique. Cependant, dans certaines applications, en particulier si les conditions d'utilisation (température ambiante, intensité du courant électrique dans la charge électrique) le permettent, on pourra trouver avantage, sans sortir du cadre de la présente invention, à utiliser comme diode de roue libre 8 une simple diode de puissance, qui est un composant moins onéreux qu'un transistor à effet de champ à grille isolée.

Dans les modes de réalisation illustrés sur les figures 2 à 5 et 7 à 10, un relais électromécanique 70 est connecté électriquement entre l'un des moyens de connexion d'entrée 10a (figures 2 à 5) ou 10b (figures 7 à 10) et le conducteur électrique d'entrée respectif 4a ou 4b destiné à être connecté à la borne positive 100a de la source d'alimentation électrique à courant continu 100. La partie contact de puissance du relais électromécanique 70 est connectée électriquement, et donc couplée thermiquement, au conducteur électrique d'entrée respectif 4a ou 4b. De plus, la bobine du relais électromécanique 70 est en couplage thermique intime avec les pièces du circuit magnétique qui lui-même constitue ou supporte le conducteur de puissance du relais, de sorte que la puissance dégagée dans la bobine est également en couplage thermique indirect avec le conducteur électrique d'entrée respectif. Les calories générées dans le relais électromécanique sont donc évacuées efficacement dans le conducteur électrique d'entrée respectif 4a ou 4b.

La présente invention n'est pas limitée aux modes de réalisation qui ont été explicitement décrits, mais elle en inclut les diverses variantes et généralisations contenues dans le domaine des revendications ci-après.

## Revendications

1. Dispositif de commande (1) pour charge électrique (2), comprenant :
- une connectique d'entrée (4), ayant un premier conducteur électrique d'entrée (4a) et un second conducteur électrique d'entrée (4b) pour sa connexion à une source d'alimentation électrique à courant continu (100),
- une connectique de sortie (5), ayant un premier conducteur électrique de sortie (5a) et un second conducteur électrique de sortie (5b) pour sa connexion à une charge électrique à commander (2),
- un composant électronique de commutation principal (6), connecté électriquement au premier conducteur électrique d'entrée (4a) par des premiers moyens de connexion d'entrée (10a), et connecté électriquement au premier conducteur électrique de sortie (5a) par des premiers moyens de connexion de sortie (11a), pour être en série avec la charge électrique à commander (2),
- une diode de roue libre (8) connectée en polarisation inverse en parallèle sur la charge électrique à commander (2), pour permettre la circulation du courant généré par une composante inductive de la charge électrique (2) lorsque le composant électronique de commutation principal (6) est bloqué,
- une commande de commutation (9), apte à générer un signal de commande (12) sensiblement carré modulé en largeur, qui pilote la commutation du composant électronique de commutation principal (6) alternativement entre un état conducteur et un état non conducteur,
- le composant électronique de commutation principal est un composant CMS,
- le composant électronique de commutation principal (6) comporte un corps couplé thermiquement à l'un des conducteurs électriques d'entrée (4a, 4b) ou de sortie (5a, 5b) par conduction au travers des premiers ou seconds moyens de connexion d'entrée (10a, 10b) ou de sortie (11a, 11b) respectifs, **caractérisé en ce que** :
- le corps du composant électronique de commutation principal (6) est monté sur un premier substrat (20) électriquement isolant,
- le premier substrat électriquement isolant (20) est structuré de façon à présenter une conductivité thermique supérieure à 0,8 W/m.°K, et de préférence supérieure ou égale à 5 W/m.°K,
- le premier substrat électriquement isolant (20) est couplé thermiquement par conduction à un autre des conducteurs électriques d'entrée (4a, 4b) ou de sortie (5a, 5b),
de sorte que des calories générées dans le composant électronique de commutation principal (6) lors de son fonctionnement sont évacuées dans au moins deux conducteurs électriques d'entrée (4a, 4b) ou de sortie (5a, 5b) distincts l'un de l'autre.

2. Dispositif de commande selon la revendication 1, **caractérisé en ce que** :
- le corps du composant électronique de commutation principal (6) est couplé thermiquement au premier conducteur électrique de sortie (5a) par conduction au travers des premiers moyens de connexion de sortie (11a),
- le premier substrat électriquement isolant (20) est couplé thermiquement par conduction à l'un des conducteurs électriques d'entrée (4a, 4b).

3. Dispositif de commande selon la revendication 2, **caractérisé en ce que** :
- les premiers moyens de connexion de sortie (11a) comprennent une première lame conductrice (30) ayant une première extrémité (31) de première lame et une deuxième extrémité (32) de première lame,
- la première extrémité (31) de première lame est connectée électriquement au composant électronique de commutation principal (6) par l'intermédiaire d'une première piste conductrice (22) portée par le premier substrat électriquement isolant (20),
- la première extrémité (31) de première lame est en contact thermique selon une première surface de contact (33) avec le premier substrat électriquement isolant (20) par l'intermédiaire de ladite première piste conductrice (22),
- la deuxième extrémité (32) de première lame est solidaire du premier conducteur électrique de sortie (5a), de façon à assurer simultanément la conduction thermique et la conduction électrique entre ladite première lame (30) et ledit premier conducteur de sortie (5a).

4. Dispositif de commande selon l'une des revendications 2 ou 3, **caractérisé en ce que** :
- le composant électronique de commutation principal est un premier transistor (6) à effet de champ à grille isolée,
- la diode de roue libre (8) est constituée par la diode de structure d'un deuxième transistor (16) à effet de champ à grille isolée de type CMS ayant un corps monté sur un deuxième substrat (21) électriquement isolant,
- la commande de commutation (9) est configurée pour mettre à l'état conducteur le deuxième transistor (16) à effet de champ à grille isolée pendant que le premier transistor (6) à effet de champ à grille isolée est à l'état non conducteur,
- le deuxième transistor (16) à effet de champ à grille isolée est connecté électriquement au deuxième conducteur électrique d'entrée (4b) par des deuxièmes moyens de connexion d'entrée (10b), et connecté électriquement au premier conducteur électrique de sortie (5a) par des deuxièmes moyens de connexion de sortie (11b), pour être en parallèle avec la charge électrique à commander (2),
- le corps du deuxième transistor (16) à effet de champ à grille isolée est couplé thermiquement au premier conducteur électrique de sortie (5a) par conduction au travers des deuxièmes moyens de connexion de sortie (11b),
- le deuxième substrat électriquement isolant (21) présente une conductivité thermique supérieure à 0,8 W/m.°K, et de préférence supérieure ou égale à 5 W/m.°K,
- le deuxième substrat électriquement isolant (21) est couplé thermiquement par conduction au deuxième conducteur électrique de sortie (5b),
de sorte que les calories générées dans le deuxième transistor (16) à effet de champ à grille isolée lors de son fonctionnement sont évacuées dans au moins deux conducteurs électriques distincts l'un de l'autre.

5. Dispositif de commande selon la revendication 4, **caractérisé en ce que** le premier substrat électriquement isolant (20) et/ou le deuxième substrat électriquement isolant (21) est en céramique, ou comprend une couche en aluminium associée à une couche électriquement isolante.

6. Dispositif de commande selon l'une des revendications 4 ou 5, **caractérisé en ce que** :
- les deuxièmes moyens de connexion de sortie (11b) comprennent une deuxième lame conductrice (35) ayant une première extrémité (36) de deuxième lame et une deuxième extrémité (37) de deuxième lame,
- la première extrémité (36) de deuxième lame est connectée électriquement au deuxième transistor 16 à effet de champ à grille isolée par l'intermédiaire d'une deuxième piste conductrice (23) portée par le deuxième substrat électriquement isolant (21),
- la première extrémité (36) de deuxième lame est en contact thermique avec le deuxième substrat électriquement isolant (21) selon une troisième surface de contact (38) par l'intermédiaire de ladite deuxième piste conductrice (23),
- la deuxième extrémité (37) de deuxième lame est solidaire du premier conducteur électrique de sortie (5a), de façon à assurer simultanément la conduction thermique et la conduction électrique entre ladite deuxième lame (35) et ledit premier conducteur de sortie (5a).

7. Dispositif de commande selon l'une quelconque des revendications 4 à 6, **caractérisé en ce que** :
- le deuxième conducteur électrique d'entrée (4b) et le deuxième conducteur électrique de sortie (5b) sont en continuité l'un de l'autre par l'intermédiaire d'une plaque métallique commune (40), et sont destinés à être connectés à une masse commune (50) et à la borne négative (100b) de la source d'alimentation électrique à courant continu (100),
- le premier conducteur électrique d'entrée (4a) est destiné à être connecté à la borne positive (100a) de la source d'alimentation électrique à courant continu (100),
- le premier substrat électriquement isolant (20) et le deuxième substrat électriquement isolant (21) forment un seul et unique substrat au contact de la plaque métallique commune (40),
de sorte que les calories générées dans le premier transistor (6) à effet de champ à grille isolée et dans le deuxième transistor (16) à effet de champ à grille isolée lors de leur fonctionnement sont évacuées à la fois dans le premier conducteur électrique de sortie (5a), dans le deuxième conducteur électrique de sortie (5b) et dans le deuxième conducteur électrique d'entrée (4b).

8. Dispositif de commande selon l'une quelconque des revendications 4 à 6, **caractérisé en ce que** :
- le deuxième conducteur électrique d'entrée (4b) et le deuxième conducteur électrique de sortie (5b) sont connectés électriquement l'un à l'autre,
- le premier conducteur électrique d'entrée (4a) est destiné à être connecté à une masse commune (50) et à la borne négative (100b) de la source d'alimentation électrique à courant continu (100),
- le deuxième conducteur électrique d'entrée (4b) est destiné à être connecté à la borne positive (100a) de la source d'alimentation électrique à courant continu (100),
- le premier substrat électriquement isolant (20) est au contact d'une première plaque métallique (41) qui est en continuité avec le premier conducteur électrique d'entrée (4a),
- le second substrat électriquement isolant (21) est au contact d'une deuxième plaque métallique (42) qui est en continuité avec le deuxième conducteur électrique de sortie (5b),
de sorte que les calories générées dans le premier transistor (6) à effet de champ à grille isolée lors de son fonctionnement sont évacuées à la fois dans le premier conducteur électrique de sortie (5a) et dans le premier conducteur électrique d'entrée (4a), et de sorte que les calories générées dans le deuxième transistor (16) à effet de champ à grille isolée lors de son fonctionnement sont évacuées à la fois dans le premier conducteur électrique de sortie (5a) et dans le deuxième conducteur électrique de sortie (5b).

9. Dispositif de commande selon l'une quelconque des revendications 1 à 8, **caractérisé en ce qu'**il comporte des moyens de radiateur de dissipation d'énergie calorifique (90) couplés thermiquement au moins au premier substrat électriquement isolant (20).

10. Dispositif de commande selon l'une quelconque des revendications 1 à 9, **caractérisé en ce que** la charge électrique (2) est un actionneur électrique tel qu'un moteur électrique à courant continu.

11. Dispositif de commande selon l'une quelconque des revendications 1 à 10, **caractérisé en ce qu'**il comprend un relais électromécanique (70) ayant un contact connecté électriquement entre l'un des moyens de connexion d'entrée (10a, 10b) et le conducteur électrique d'entrée (4a, 4b) destiné à être connecté à la borne positive (100a) de la source d'alimentation électrique à courant continu (100), et ayant une bobine de commande de commutation dudit contact qui est couplée thermiquement audit conducteur électrique d'entrée (4a, 4b) destiné à être connecté à la borne positive (100a) de la source d'alimentation électrique à courant continu (100).

12. Véhicule automobile à échangeur thermique et ventilateur actionné par un moteur électrique (2) pour ventiler l'échangeur thermique, **caractérisé en ce que** le moteur électrique (2) est commandé par un dispositif de commande (1) selon l'une quelconque des revendications 1 à 11.

13. Véhicule automobile selon la revendication 12, **caractérisé en ce que** :
- le ventilateur est monté sur un support transversal de fixation sensiblement plan à première face opposée à une deuxième face, le ventilateur étant apte à générer un flux d'air traversant le support depuis la première face vers la deuxième face,
- le support transversal de fixation comporte, en périphérie du ventilateur, une lumière de fixation pour la réception du dispositif de commande,
- le dispositif de commande (1) est fixé dans ladite lumière,
- le ou les conducteurs électriques de sortie (5a,5b) du dispositif de commande (1) traversent un flux d'air généré par le ventilateur.

## Patentansprüche

1. Steuervorrichtung (1) für elektrische Last (2), umfassend:
- einen Eingangsverbinder (4), aufweisend einen ersten elektrischen Eingangsleiter (4a) und einen zweiten elektrischen Eingangsleiter (4b) zu dessen Verbindung an eine elektrische Gleichstromquelle (100),
- einen Ausgangsverbinder (5), aufweisend einen ersten elektrischen Ausgangsleiter (5a) und einen zweiten elektrischen Ausgangsleiter (5b) zu dessen Verbindung an eine zu steuernde elektrische Last (2),
- eine elektronische Hauptschaltkomponente (6) elektrisch verbunden mit dem ersten elektrischen Eingangsleiter (4a) mit ersten Eingangsverbindungsmitteln (10a), und elektrisch verbunden mit dem ersten elektrischen Ausgangsleiter (5a) mit ersten Ausgangsverbindungsmitteln (11a), um in Reihe mit der zu steuernden elektrischen Last (2) zu sein,
- eine Freilaufdiode (8), verbunden mit inverser Polarität parallel zu der zu steuernden elektrischen Last (2), um den Stromfluss zur erlauben, der durch eine induktive Komponente der elektrischen Last (2) erzeugt ist, wenn die elektronischen Hauptschaltkomponente (6) blockiert ist,
- eine Schaltsteuerung (9), die in der Lage ist, ein im Wesentlichen quadratisch breitenmoduliertes Steuersignal (12) zu erzeugen, das das Schalten der elektronischen Hauptschaltkomponente (6) alternierend zwischen einem leitenden Zustand und einem nichtleitenden Zustand pilotiert,
- die elektronische Hauptschaltkomponente ist eine SMD-Komponente,
- die elektronische Hauptschaltkomponente (6) weist einen Körper auf, der thermisch gekoppelt ist mit einem der elektrischen Eingangsleiter (4a, 4b) oder Ausgangsleiter (5a, 5b) durch Leitung durch die jeweiligen ersten oder zweiten Eingangsverbindungs- (10a, 10b) oder Auslassverbindungsmittel (11a, 11b),
**dadurch gekennzeichnet, dass:**
- der Körper der elektronischen Hauptschaltkomponente (6) auf einem ersten elektrisch isolierenden Substrat (20) montiert ist,
- das erste elektrisch isolierende Substrat (20) derart strukturiert ist, dass es eine thermische Leitfähigkeit von mehr als 0,8 W/m.°K aufweist und vorzugsweise größer oder gleich 5 W/m.°K,
- das erste elektrisch isolierende Substrat (20) thermisch durch Leitung mit einem anderen der elektrischen Eingangs- (4a, 4b) oder Ausgangsleiter (5a, 5b) gekoppelt ist,
- sodass Wärmemengen, die in der elektronischen Hauptschaltkomponente (6) erzeugt werden, während ihres Betriebes in mindestens zwei voneinander verschiedenen elektrischen Eingangs- (4a, 4b) oder Ausgangsleitern (5a, 5b) abgeführt wird.

2. Steuervorrichtung nach Anspruch 1, **dadurch gekennzeichnet, dass**:
- der Körper der elektronischen Hauptschaltkomponente (6) thermisch mit dem ersten elektrischen Ausgangsleiter (5a) durch Leitung durch das erste Ausgangsverbindungsmittel (11a) gekoppelt ist,
- das erste elektrisch isolierende Substrat (20) durch Leitung mit einem der elektrischen Eingangsleiter (4a, 4b) thermisch gekoppelt ist.

3. Steuervorrichtung nach Anspruch 2, **dadurch gekennzeichnet, dass**:
- die ersten Auslassverbindungsmittel (11a) eine erste leitfähige Lamelle (30) umfassen, aufweisend ein erstes Ende (31) der ersten Lamelle und ein zweites Ende (32) der ersten Lamelle,
- das erste Ende (31) der ersten Lamelle mittels einer ersten Leiterbahn (22), die von dem ersten elektrisch isolierenden Substrat (20) getragen wird, elektrisch mit der elektronischen Hauptschaltkomponente (6) verbunden ist,
- das erste Ende (31) der ersten Lamelle entlang einer ersten Kontaktfläche (33) in thermischem Kontakt mit dem ersten elektrisch isolierenden Substrat (20) mittels besagter erster Leiterbahn (22) steht,
- das zweite Ende (32) der ersten Lamelle mit dem ersten elektrischen Ausgangsleiter (5a) derart fest verbunden ist, um so gleichzeitig die thermische Leitung und die elektrische Leitung zwischen besagter ersten Lamelle (30) und besagtem ersten Ausgangsleiter (5a) sicherzustellen.

4. Steuervorrichtung nach einem der Ansprüche 2 oder 3, **dadurch gekennzeichnet, dass**:
- die elektronische Hauptschaltkomponente ein erster Isoliergate-Feldeffekttransistor (6) ist,
- die Freilaufdiode (8) durch die Diode mit der Struktur eines zweiten SMD-Typ Isoliergate-Feldeffekttransistor (16) gebildet wird, der einen Körper aufweist, der auf einem zweiten elektrisch isolierenden Substrat (21) montiert ist,
- die Schaltsteuerung (9) so konfiguriert ist, den zweiten Isoliergate-Feldeffekttransistor (16) in leitenden Zustand zu versetzen, während der erste Isoliergate-Feldeffekttransistor (6) in einem nicht leitenden Zustand ist,
- der zweite Isoliergate-Feldeffekttransistor (16) elektrisch mit dem zweiten elektrischen Eingangsleiter (4b) mit zweiten Eingangsverbindungsmitteln (10b) verbunden ist, und elektrisch mit dem ersten elektrischen Ausgangsleiter (5a) mit zweiten Ausgangsverbindungsmitteln (11b), parallel zur zu steuernden elektrischen Last (2) verbunden ist,
- der Körper des zweiten Isoliergate-Feldeffekttransistors (16) thermisch mit dem ersten elektrischen Ausgangsleiter (5a) durch Leitung durch zweite Ausgangsverbindungsmittel (11b) gekoppelt ist,
- das zweite elektrisch isolierende Substrat (21) eine thermische Leitfähigkeit von mehr als 0,8 W/m.°K aufweist, und vorzugsweise größer oder gleich 5 W/m.°K,
- das zweite elektrisch isolierende Substrat (21) durch Leitung mit dem zweiten elektrischen Ausgangsleiter (5b) thermisch gekoppelt ist, so dass die im zweiten Isoliergate-Feldeffekttransistor (16) während seines Betriebs erzeugten Wärmemengen in mindestens zwei voneinander verschiedene elektrische Leiter abgeleitet werden.

5. Steuervorrichtung nach Anspruch 4, **dadurch gekennzeichnet, dass** das erste elektrisch isolierende Substrat (20) und/oder das zweite elektrisch isolierende Substrat (21) aus Keramik sind oder eine mit einer elektrisch isolierenden Schicht verbundene Aluminiumschicht umfassen.

6. Steuervorrichtung nach einem der Ansprüche 4 oder 5, **dadurch gekennzeichnet, dass**:
- die zweiten Auslassverbindungsmittel (11b) eine zweite leitfähige Lamelle (35) mit einem ersten Ende (36) der zweiten Lamelle und einem zweiten Ende (37) der zweiten Lamelle umfasst,
- das erste Ende (36) der zweiten Lamelle elektrisch mit dem zweiten Isoliergate-Feldeffekttransistor 16 mittels einer zweiten Leiterbahn (23) verbunden ist, die von dem zweiten elektrisch isolierenden Substrat (21) getragen wird,
- das erste Ende (36) der zweiten Lamelle entlang einer dritten Kontaktfläche (38) in thermischem Kontakt mit dem zweiten elektrisch isolierenden Substrat (21) mittels besagter zweiten Leiterbahn (23) steht,
- das zweite Ende (37) der zweiten Lamelle mit dem ersten elektrischen Ausgangsleiter (5a) derart fest verbunden ist, um so gleichzeitig die thermische Leitung und die elektrische Leitung zwischen besagter zweiter Lamelle (35) und dem ersten Ausgangsleiter (5a) sicherzustellen.

7. Steuervorrichtung nach einem der Ansprüche 4 bis 6, **dadurch gekennzeichnet, dass**:
- der zweite elektrische Eingangsleiter (4b) und der zweite elektrische Ausgangsleiter (5b) in Kontinuität miteinander mittels einen gemeinsamen Metallplatte (40) sind und dazu vorgesehen sind, mit einer gemeinsamen Masse (50) und mit dem Minuspol (100b) der elektrischen Gleichstromquelle (100) verbunden zu werden,
- der erste elektrische Eingangsleiter (4a) vorgesehen ist, mit dem Pluspol (100a) der elektrischen Gleichstromquelle (100) verbunden zu werden,
- das erste elektrisch isolierende Substrat (20) und das zweite elektrisch isolierende Substrat (21) ein einzelnes Substrat in Kontakt mit der gemeinsamen Metallplatte (40) bilden,
so dass die Wärmemengen, die in dem ersten Isoliergate-Feldeffekttransistor (6) und in dem zweiten Isoliergate-Feldeffekttransistor (16) während ihres Betriebes erzeugt werden, sowohl in dem ersten elektrischen Ausgangsleiter (5a), in dem zweiten elektrischen Ausgangsleiter (5b) und im zweiten elektrischen Eingangsleiter (4b) abgeführt werden.

8. Steuervorrichtung nach einem der Ansprüche 4 bis 6, **dadurch gekennzeichnet, dass**:
- der zweite elektrische Eingangsleiter (4b) und der zweite elektrische Ausgangsleiter (5b) elektrisch miteinander verbunden sind,
- der erste elektrische Eingangsleiter (4a) vorgesehen ist, mit einer gemeinsamen Masse (50) und mit dem Minuspol (100b) der elektrischen Gleichstromquelle (100) verbunden zu werden,
- der zweite elektrische Eingangsleiter (4b) vorgesehen ist, mit dem Pluspol (100a) der elektrischen Gleichstromquelle (100) verbunden werden,
- das erste elektrisch isolierende Substrat (20) in Kontakt mit einer ersten Metallplatte (41) steht, die in Kontinuität mit dem ersten elektrischen Eingangsleiter (4a) ist,
- das zweite elektrisch isolierende Substrat (21) in Kontakt mit einer zweiten Metallplatte (42) steht, die in Kontinuität mit dem zweiten elektrischen Ausgangsleiter (5b) ist,
so dass die erzeugte Wärmemengen in dem ersten Isoliergate-Feldeffekttransistor (6) während ihres Betriebes sowohl in dem ersten elektrischen Ausgangsleiter (5a) und in dem ersten elektrischen Eingangsleiter (4a) abgeführt werden und so, dass die erzeugten Wärmemengen in dem zweiten Isoliergate-Feldeffekttransistor (16) während ihres Betriebes wird sowohl in dem ersten elektrischen Ausgangsleiter (5a) und in dem zweiten elektrischen Ausgangsleiter (5b) abgeführt werden.

9. Steuervorrichtung nach einem der Ansprüche 1 bis 8, **dadurch gekennzeichnet, dass** sie Mittel zur Abstrahlung von Wärmeenergie (90) aufweist, die zumindest mit dem ersten elektrisch isolierenden Substrat (20) thermisch gekoppelt sind.

10. Steuervorrichtung nach einem der Ansprüche 1 bis 9, **dadurch gekennzeichnet, dass** die elektrische Last (2) ein elektrischer Aktuator wie ein Gleichstrom-Elektromotor ist.

11. Steuervorrichtung nach einem der Ansprüche 1 bis 10, **dadurch gekennzeichnet, dass** sie ein elektromechanisches Relais (70) umfasst, aufweisend einen Kontakt, der elektrisch verbindend zwischen einem der Eingangsverbindungsmittel (10a, 10b) und dem elektrischen Eingangsleiter (4a, 4b) vorgesehen ist zur Verbindung mit dem Pluspol (100a) der elektrischen Gleichstromquelle (100), und aufweisend eine Schaltsteuerspule besagten Kontakts, der mit dem elektrischen Eingangsleiter (4a, 4b) thermisch gekoppelt ist, vorgesehen zur Verbindung mit besagtem Pluspol (100a) der elektrischen Gleichstromquelle (100).

12. Kraftfahrzeug mit Wärmetauscher und Lüfter betätigt durch einen Elektromotor (2) zur Belüftung des Wärmetauschers, **dadurch gekennzeichnet, dass** der Elektromotor (2) durch eine Steuervorrichtung (1) nach einem der Ansprüche 1 bis 11 gesteuert wird.

13. Kraftfahrzeug nach Anspruch 12, **dadurch gekennzeichnet, dass**:
- der Lüfter an einem quer verlaufenden Befestigungsträger montiert ist, der im Wesentlichen eben ist, wobei eine erste Fläche einer zweiten Fläche gegenüberliegt, wobei der Lüfter in der Lage ist, einen Luftstrom zu erzeugen, der den Träger von der ersten Fläche zur zweiten Fläche durchströmt,
- der quer verlaufende Befestigungsträger in der Peripherie des Lüfters eine Befestigungsöffnung zur Aufnahme des Steuergeräts aufweist,
- die Steuervorrichtung (1) in diesem Lumen befestigt ist,
- der oder die elektrischen Ausgangsleiter (5a, 5b) der Steuervorrichtung (1) von einem vom Lüfter erzeugten Luftstrom durchströmt werden.

## Claims

1. Control device (1) for an electrical load (2), said device comprising:
- an input connector (4), having a first input electrical conductor (4a) and a second input electrical conductor (4b) for connection thereof to a DC electrical power source (100),
- an output connector (5), having a first output electrical conductor (5a) and a second output electrical conductor (5b) for connection thereof to an electrical load (2) to be controlled,
- a main switching electronic component (6) that is electrically connected to the first input electrical conductor (4a) by first input connecting means (10a), and that is electrically connected to the first output electrical conductor (5a) by first output connecting means (11a), in order to be in series with the electrical load (2) to be controlled,
- a flyback diode (8) that is connected so as to be reverse biased in parallel with the electrical load (2) to be controlled, in order to allow the current generated by an inductive component of the electrical load (2) to flow when the main switching electronic component (6) is turned off,
- a switch controller (9) able to generate a substantially square-wave width-modulated control signal (12) that drives the switching of the main switching electronic component (6) alternatively between an on state and an off state;
- the main switching electronic component is an SMC;
- the main switching electronic component (6) comprises a body that is thermally coupled to one of the input or output electrical conductors (4a, 4b) or (5a, 5b) respectively) by conduction through respective first or second input or output connecting means (10a, 10b or 11a, 11b respectively);
**characterized in that**:
- the body of the main switching electronic component (6) is mounted on a first electrically insulating substrate (20),
- the first electrically insulating substrate (20) is structured so as to have a thermal conductivity higher than 0.8 W/m.°K, and preferably higher than or equal to 5 W/m.°K,
- the first electrically insulating substrate (20) is thermally coupled by conduction to another of the input or output electrical conductors (4a, 4b or 5a, 5b respectively),
so that the heat generated in the main switching electronic component (6) during the operation thereof is evacuated to at least two input or output electrical conductors (4a, 4b or 5a, 5b respectively) that are separate from one another.

2. Control device according to Claim 1, **characterized in that**:
- the body of the main switching electronic component (6) is thermally coupled to the first output electrical conductor (5a) by conduction through the first output connecting means (11a),
- the first electrically insulating substrate (20) is thermally coupled by conduction to one of the input electrical conductors (4a, 4b).

3. Control device according to Claim 2, **characterized in that**:
- the first output connecting means (11a) comprise a first conductive tab (30) having a first first-tab end (31) and a second first-tab end (32),
- the first first-tab end (31) is electrically connected to the main switching electronic component (6) via a first conductive track (22) borne by the first electrically insulating substrate (20),
- the first first-tab end (31) makes thermal contact, in a first area of contact (33), with the first electrically insulating substrate (20), via said first conductive track (22),
- the second first-tab end (32) is securely fastened to the first output electrical conductor (5a), so as to simultaneously ensure thermal conduction and electrical conduction between said first tab (30) and said first output conductor (5a).

4. Control device according to either of Claims 2 and 3,
**characterized in that**:
- the main switching electronic component is a first insulated-gate field-effect transistor (6),
- the flyback diode (8) consists of the structural diode of an SMC second insulated-gate field-effect transistor (16) having a body mounted on a second electrically insulating substrate (21),
- the switch controller (9) is configured to turn on the second insulated-gate field-effect transistor (16) when the first insulated-gate field-effect transistor (6) is in the off state,
- the second insulated-gate field-effect transistor (16) is electrically connected to the second input electrical conductor (4b) by second input connecting means (10b), and electrically connected to the first output electrical conductor (5a) by second output connecting means (11b), in order to be in parallel with the electrical load (2) to be controlled,
- the body of the second insulated-gate field-effect transistor (16) is thermally coupled to the first output electrical conductor (5a) by conduction through the second output connecting means (11b),
- the second electrically insulating substrate (21) has a thermal conductivity higher than 0.8 W/m.°K, and preferably higher than or equal to 5 W/m.°K,
- the second electrically insulating substrate (21) is thermally coupled by conduction to the second output electrical conductor (5b),
so that the heat generated in the second insulated-gate field-effect transistor (16) during the operation thereof is evacuated to at least two electrical conductors that are separate from one another.

5. Control device according to Claim 4, **characterized in that** the first electrically insulating substrate (20) and/or the second electrically insulating substrate (21) is made of ceramic, or comprises a layer made of aluminum associated with an electrically insulating layer.

6. Control device according to either of Claims 4 and 5,
**characterized in that**:
- the second output connecting means (11b) comprise a second conductive tab (35) having a first second-tab end (36) and a second second-tab end (37),
- the first second-tab end (36) is electrically connected to the second insulated-gate field-effect transistor (16) via a second conductive track (23) borne by the second electrically insulating substrate (21),
- the first second-tab end (36) makes thermal contact with the second electrically insulating substrate (21), in a third area of contact (38), via said second conductive track (23),
- the second second-tab end (37) is securely fastened to the first output electrical conductor (5a), so as to simultaneously ensure thermal conduction and electrical conduction between said second tab (35) and said first output conductor (5a).

7. Control device according to any one of Claims 4 to 6,
**characterized in that**:
- the second input electrical conductor (4b) and the second output electrical conductor (5b) are in continuity with each other via a common metal plate (40), and are intended to be connected to a common ground (50) and to the negative terminal (100b) of the DC electrical power source (100),
- the first input electrical conductor (4a) is intended to be connected to the positive terminal (100a) of the DC electrical power source (100), and
- the first electrically insulating substrate (20) and the second electrically insulating substrate (21) form one and the same substrate, which makes contact with the common metal plate (40),
so that the heat generated in the first insulated-gate field-effect transistor (6) and in the second insulated-gate field-effect transistor (16) during the operation thereof is evacuated to the first output electrical conductor (5a), to the second output electrical conductor (5b) and to the second input electrical conductor (4b).

8. Control device according to any one of Claims 4 to 6,
**characterized in that**:
- the second input electrical conductor (4b) and the second output electrical conductor (5b) are electrically connected to each other,
- the first input electrical conductor (4a) is intended to be connected to a common ground (50) and to the negative terminal (100b) of the DC electrical power source (100),
- the second input electrical conductor (4b) is intended to be connected to the positive terminal (100a) of the DC electrical power source (100),
- the first electrically insulating substrate (20) makes contact with a first metal plate (41) that is in continuity with the first input electrical conductor (4a), and
- the second electrically insulating substrate (21) makes contact with a second metal plate (42) that is in continuity with the second output electrical conductor (5b),
so that the heat generated in the first insulated-gate field-effect transistor (6) during the operation thereof is evacuated both to the first output electrical conductor (5a) and to the first input electrical conductor (4a), and so that the heat generated in the second insulated-gate field-effect transistor (16) during the operation thereof is evacuated both to the first output electrical conductor (5a) and to the second output electrical conductor (5b).

9. Control device according to any one of Claims 1 to 8, **characterized in that** it comprises heat-dissipating radiating means (90) that are thermally coupled at least to the first electrically insulating substrate (20) .

10. Control device according to any one of Claims 1 to 9, **characterized in that** the electrical load (2) is an electrical actuator such as a DC electrical motor.

11. Control device according to any one of Claims 1 to 10, **characterized in that** it comprises an electromechanical relay (70) that has a contact electrically connected between one of the input connecting means (10a, 10b) and the input electrical conductor (4a, 4b) intended to be connected to the positive terminal (100a) of the DC electrical power source (100), and that has a control coil for switching said contact, which coil is thermally coupled to said input electrical conductor (4a, 4b) intended to be connected to the positive terminal (100a) of the DC electrical power source (100).

12. Motor vehicle comprising a heat exchanger and a cooling fan that is actuated by an electrical motor (2) in order to blow air over the heat exchanger, **characterized in that** the electrical motor (2) is controlled by a control device (1) according to any one of Claims 1 to 11.

13. Motor vehicle according to Claim 12, **characterized in that**:
- the cooling fan is mounted on a substantially planar transverse attachment carrier having a first face opposite a second face, the cooling fan being able to generate an airflow that passes through the carrier from the first face to the second face,
- the transverse attachment carrier comprises, on the periphery of the cooling fan, an attachment window for accommodating the control device,
- the control device (1) is attached in said window,
- the one or more output electrical conductors (5a,5b) of the control device (1) pass through an airflow generated by the cooling fan.
